# EUROPEAN PATENT APPLICATION

(11) **EP 4 391 504 A1**
(43) Date of publication of application: **26.06.2024**
(21) Application number: 23853722.9
(22) Date of filing: 01.11.2023
(51) Int. Cl.: H04M 1/02, G09F 9/30, G06F 1/16

(54) **ELECTRONIC APPARATUS INCLUDING DISPLAY PROTECTIVE MEMBER**

(30) Priority: 01.11.2022 KR 20220143963; 26.12.2022 KR 20220184290
(71) Applicant: Samsung Electronics Co., Ltd., Suwon-si, Gyeonggi-do 16677 (KR)
(72) Inventor: JUNG, Dongsoo, Suwon-si, Gyeonggi-do 16677 (KR); KIM, Geonsik, Suwon-si, Gyeonggi-do 16677 (KR); KIM, Youngtae, Suwon-si, Gyeonggi-do 16677 (KR); KIM, Juwon, Suwon-si, Gyeonggi-do 16677 (KR); SONG, Bomina, Suwon-si, Gyeonggi-do 16677 (KR); LEE, Hyungjin, Suwon-si, Gyeonggi-do 16677 (KR); CHO, Younggyun, Suwon-si, Gyeonggi-do 16677 (KR); CHO, Yonghyun, Suwon-si, Gyeonggi-do 16677 (KR); HWANG, Juntak, Suwon-si, Gyeonggi-do 16677 (KR)
(74) Representative: HGF
(86) International application number: PCT/KR2023/017316
(87) International publication number: WO 2024/096599

(57) **Abstract**

An electronic device including a display protection member is disclosed. An electronic device according to various embodiments of the disclosure is an electronic device including a flexible display panel, and may include a flexible window disposed in a first direction, in which the flexible display panel displays an image, to protect the flexible display panel, and configured to be bent and unbent about a bending axis. The flexible window may include a first part which is located in an area of the flexible window relatively close to the bending axis, includes a first recess formed by the area of the flexible window being recessed, and is bent and unbent about the bending axis, and a second part which is thicker than the first part and is located in an area of the flexible window relatively distant from the bending axis, wherein the first part includes a reinforcement part formed to be oriented in a direction parallel to the bending axis.

## Description

### [Technical Field]

Various embodiments disclosed herein relate to an electronic device and, more particularly, to an electronic device including a display protection member.

### [Background Art]

Electronic devices require a small profile for portability and a large display area to provide a lot of information to a user. In order to reconcile the small profile and large display area of electronic devices, various form factors such as rollable, slidable, or foldable have emerged, moving away from the traditional rectangular bar-shaped form factor. Electronic devices with a form factor such as foldable require a flexible display that can be bent.

A display of an electronic device may include a display protection member, such as a window, that protects a panel layer by preventing foreign matter from entering from the top of the panel layer. A flexible display used in electronic devices with form factors such as rollable, slidable, or foldable requires a flexible window that can be bent or folded with the display panel.

A polymer material such as transparent polyimide may be used as the material of the flexible window, but the polymer material has low scratch resistance and resistance to repeated bending, so a glass material such as ultra-thin glass, which has both high hardness and flexibility, may be used as a window material.

### [Disclosure of Invention]

### [Solution to Problem]

Due to its thinness, ultra-thin glass is vulnerable to external impact, which may lead to breakage. When the thickness of a flexible is increased to improve the impact resistance of the window and prevent breakage, the flexibility and pliability of the flexible display window may be reduced. To solve this problem, the thickness of a first part, which is the part where bending occurs in a flexible display window, may be reduced. However, when different parts of glass have different thicknesses, warpage may occur during glass tempering (e.g., thermal and/or chemical tempering) due to an imbalance of stresses caused by the different thicknesses.

Various embodiments of the disclosure may provide a display protection member with reduced warpage at a first part, and an electronic device including the same.

An electronic device according to various embodiments of the disclosure is an electronic device including a flexible display panel, and may include a flexible window disposed in a first direction, in which the flexible display panel displays an image, to protect the flexible display panel, and configured to be bent and unbent about a bending axis. The flexible window may include a first part which is located in an area of the flexible window relatively close to the bending axis, includes a first recess formed by the area of the flexible window being recessed, and is bent and unbent about the bending axis, and a second part which is thicker than the first part and is located in an area of the flexible window relatively distant from the bending axis, wherein the first part includes a reinforcement part formed to be oriented in a direction parallel to the bending axis.

In various embodiment, the reinforcement part may include a rib protruding from the first part.

In various embodiment, the rib may be located at a center of the first part with respect to the bending axis.

In various embodiment, the reinforcement part may include reinforcement grooves recessed from a surface of the first part.

In various embodiment, the reinforcement grooves may be located to be symmetrically spaced apart from the center of the first part with respect to the bending axis.

In various embodiment, the electronic device may include a second recess formed on a surface opposite to the first recess with respect to a thickness direction of the flexible window.

In various embodiment, a boundary between the first part and the second part may have a tapered shape in a thickness direction.

In various embodiment, the flexible window may include a transparent polymer layer located in the recessed area of the first part.

In various embodiment, a thickness of the second part may exceed 30 micrometers.

In various embodiment, the flexible window may be manufactured by a method which includes a reinforcement part processing operation of processing and forming the reinforcement part by recessing a surface of the flexible window, a masking operation of locating a mask formed to cover a surface of the second part and expose an area corresponding to the first recess with respect to a surface of the glass layer, and an etching operation of etching the first recess.

A flexible window according to various embodiments of the disclosure is a flexible window disposed in a first direction, in which a flexible display panel displays an image in an electronic device including the flexible display panel, to protect the flexible display panel, and configured to be bent and unbent about a bending axis. The flexible window may include a first part which is located in an area of the flexible window relatively close to the bending axis, includes a first recess formed by the area of the flexible window being recessed, and is bent and unbent about the bending axis, and a second part which is thicker than the first part and is located in an area of the flexible window relatively distant from the bending axis, wherein the first part includes a reinforcement part formed to be oriented in a direction parallel to the bending axis.

In various embodiment, the reinforcement part may include a rib protruding from the first part.

In various embodiment, the rib may be located at a center of the first part with respect to the bending axis.

In various embodiment, the reinforcement part may include reinforcement grooves recessed from a surface of the first part.

In various embodiment, the reinforcement grooves may be located to be symmetrically spaced apart from the center of the first part with respect to the bending axis.

In various embodiment, the flexible window may include a second recess formed on a surface opposite to the first recess with respect to a thickness direction of the flexible window.

In various embodiment, a boundary between the first part and the second part may have a tapered shape in a thickness direction.

In various embodiment, the flexible window may include a transparent polymer layer located in the recessed area of the first part.

In various embodiment, a thickness of the second part may exceed 30 micrometers.

In various embodiment, the flexible window may be manufactured by a method which includes a reinforcement part processing operation of processing and forming the reinforcement part by recessing a surface of the flexible window, a masking operation of locating a mask formed to cover a surface of the second part and expose an area corresponding to the first recess with respect to a surface of the glass layer, and an etching operation of etching the first recess.

In various embodiment, puncture resistance of the second part and the first part may be 3 kgf or more.

In various embodiment, in the first part, the glass layer may be configured not to be broken during a pen drop test from a height of at least 6 cm.

In various embodiment, in the first part, the glass layer may be configured not to be broken by a pen tip during a pen pressing test with a force of at least 0.3 kgf.

In various embodiment, in case that the flexible window is bent, a radius of curvature of the first part may be less than or equal to 0.5 mm.

According to various embodiments disclosed herein, the first part of the flexible window may include a rigid reinforcement part, thereby reducing warpage due to stress imbalance in the first part.

### [Brief Description of Drawings]

In describing the drawings, the same or similar reference signs may be used for the same or similar elements.
FIG. 1 is a block diagram of an electronic device in a network environment according to various embodiments.
FIGS. 2A to 2F illustrate a portable electronic device having an in-folding housing structure according to an embodiment.
FIG. 3A is a plan view illustrating a flexible display of an electronic device according to various embodiments of the disclosure.
FIG. 3B is a cross-sectional view illustrating a flexible display according to various embodiments.
FIG. 3C is a cross-sectional view illustrating a flexible display according to various embodiments.
FIG. 4A is a schematic view illustrating a stress applied during tempering of a flexible window according to a comparative example.
FIGS. 4B and 4C are schematic views illustrating stresses applied during tempering of a flexible window according to embodiments of the disclosure.
FIG. 5A is a side view illustrating the bent state of a flexible window according to a comparative example.
FIGS. 5B and 5C are side views illustrating the bent state of a flexible window according to embodiments of the disclosure.
FIG. 6 is a schematic diagram illustrating a manufacturing process of a flexible window according to various embodiments.
FIGS. 7A to 7C are cross-sectional views illustrating a flexible window according to various embodiments.
FIG. 8 is a perspective view of a test device for first evaluation, second evaluation, and third evaluation and a view showing the test device according to an embodiment.
FIG. 9 is a graph showing a minimum surface compressive stress that a glass layer must have to substantially prevent breakage of a glass layer depending on the drop height of a pen input device according to an embodiment.
FIG. 10 is a graph showing the drop height of a pen input device that causes breakage of a glass layer depending on a thickness of the glass layer as a first evaluation of a laminate including the glass layer in FIG. 3 according to an embodiment.
FIG. 11 is a view illustrating a test device and a glass layer in conjunction with a first evaluation, and a view illustrating a test device and a glass layer in conjunction with a second evaluation according to an embodiment.
FIG. 12 is a graph showing the drop height of a pen input device that causes breakage of a glass layer depending on the thickness of the glass layer as a result of a first evaluation using a test device, and a graph showing a pressing load through the pen input device that causes breakage of the glass layer depending on the thickness of the glass layer as a result of a second evaluation using the test device, according to an embodiment.
FIG. 13 is a graph showing a breaking load depending on the thickness of a glass layer as a result of a third evaluation using a test device (e.g., a puncture resistance evaluation based on the ASTM F1306-16 standard), according to an embodiment.
FIG. 14 is a cross-sectional view illustrating the glass layer in the folded state of the electronic device, and a graph showing the minimum radius of curvature that allows the glass layer to be bent without breaking depending on the thickness of the glass layer, according to an embodiment.

### [Best Mode for the Invention]

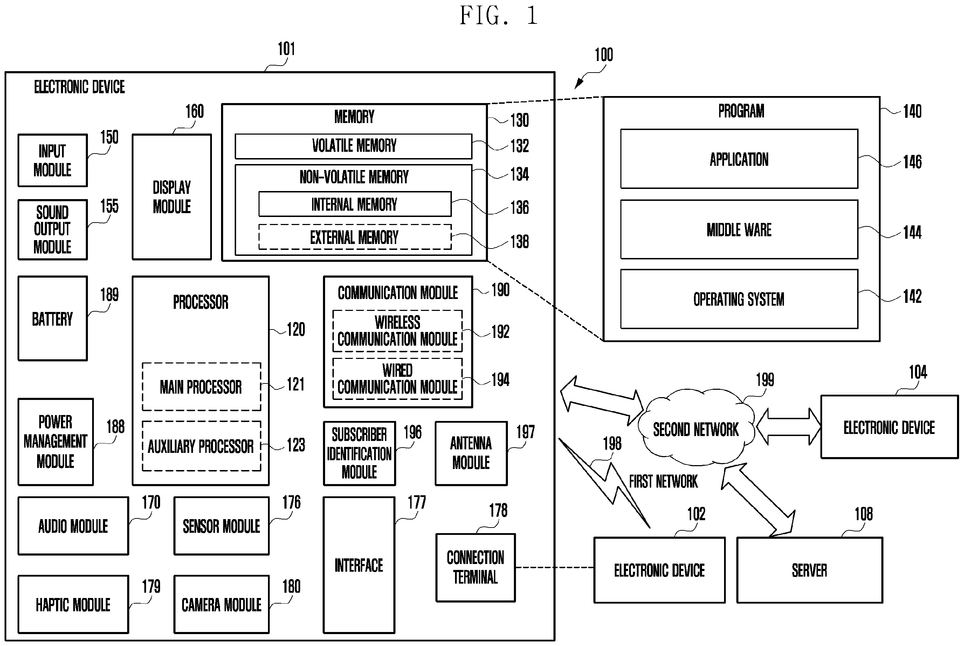

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input 1module 150, a sound output 1module 155, a display 1module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display 1module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input 1module 150 may receive a command or data to be used by another component (e.g., the processor 120) of the electronic device 101, from the outside (e.g., a user) of the electronic device 101. The input 1module 150 may include, for example, a microphone, a mouse, a keyboard, a key (e.g., a button), or a digital pen (e.g., a stylus pen).

The sound output 1module 155 may output sound signals to the outside of the electronic device 101. The sound output 1module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display 1module 160 may visually provide information to the outside (e.g., a user) of the electronic device 101. The display 1module 160 may include, for example, a display, a hologram device, or a projector and control circuitry to control a corresponding one of the display, hologram device, and projector. According to an embodiment, the display 1module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input 1module 150, or output the sound via the sound output 1module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program #40) including one or more instructions that are stored in a storage medium (e.g., internal memory #36 or external memory #38) that is readable by a machine (e.g., the electronic device #01). For example, a processor (e.g., the processor #20) of the machine (e.g., the electronic device #01) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, a portable electronic device (e.g., the electronic device 101 in FIG. 1) may have a foldable housing that is divided into two housings about a folding axis. A first part of a display (e.g., a flexible display) may be disposed in a first housing, and a second part of the display may be disposed in the second housing. The foldable housing may be implemented in an in-folding manner in which the first part and the second part face each other when the portable electronic device is folded. Alternatively, the foldable housing may be implemented in an out-folding manner in which the first part and the second part face each other in opposite directions when the portable electronic device is folded. A surface on which the first part and the second part of the display are disposed may be defined as the front surface of the portable electronic device, the opposite surface may be defined as the rear surface of the portable electronic device, and a surface surrounding the space between the front surface and the rear surface may be defined as the side surface of the portable electronic device.

According to the embodiments described herein, in-folding, in which the first part of the display in the first housing is disposed to face the second part of the display in the second housing when the display of the portable electronic device is folded, has been illustrated and described as an example. However, according to an embodiment, the same may be applied to out-folding in which the first part of the display in the first housing is disposed to face an opposite direction to the second part of the display in the second housing when the display is folded. In addition, the embodiments may be applied to a multi-foldable electronic device in which in-folding and in-folding are combined, in-folding and out-folding are combined, and out-folding and out-folding are combined.

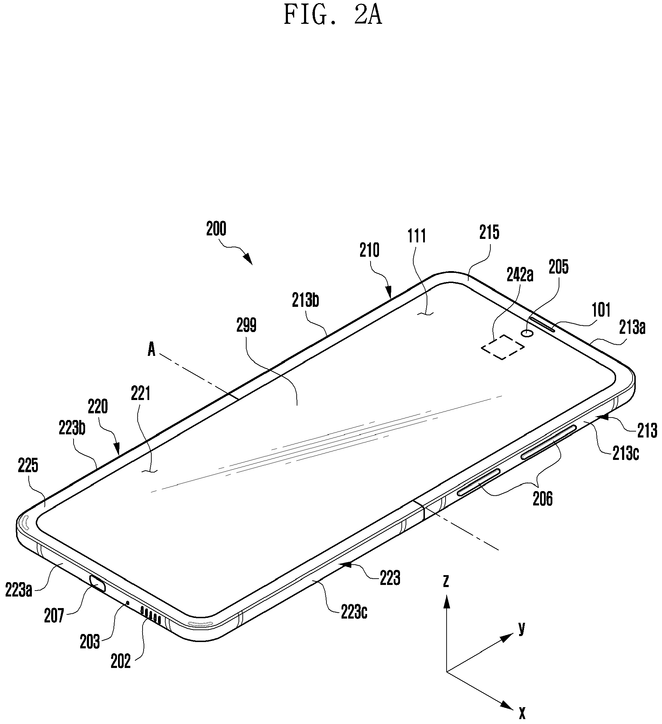

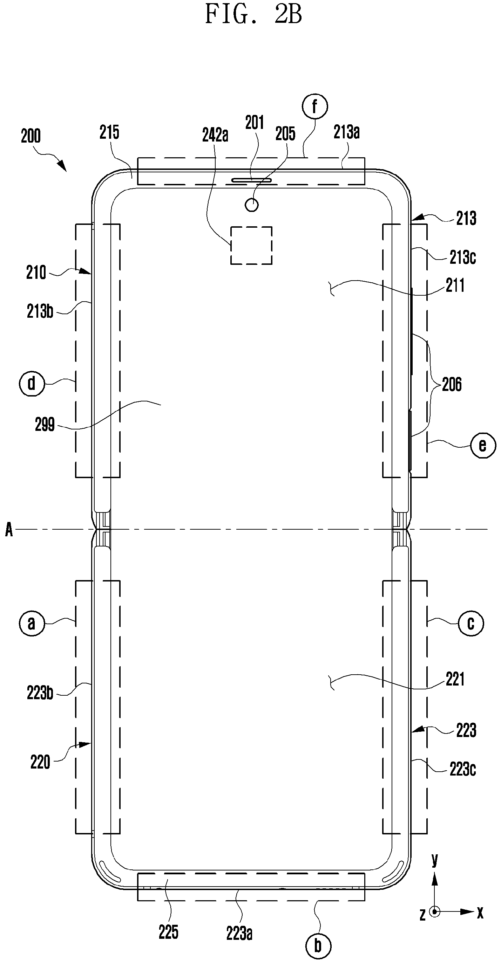

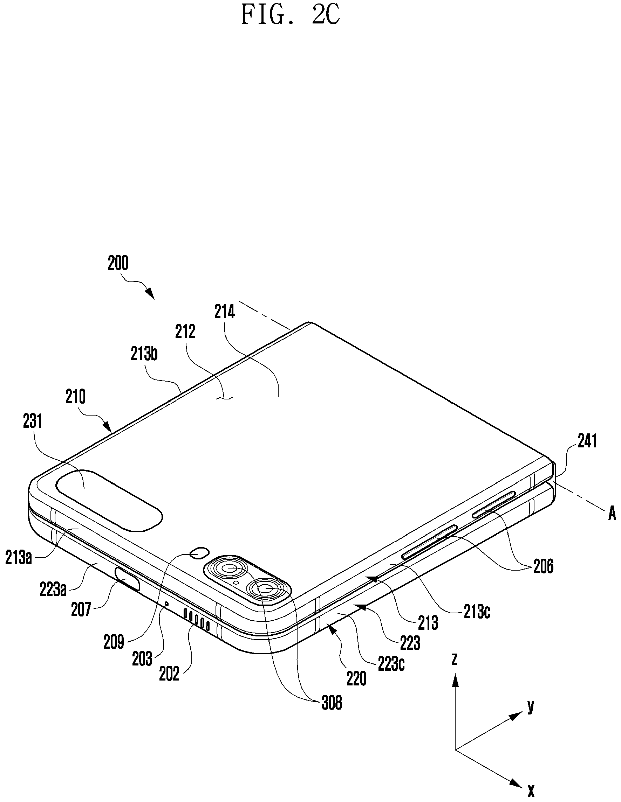

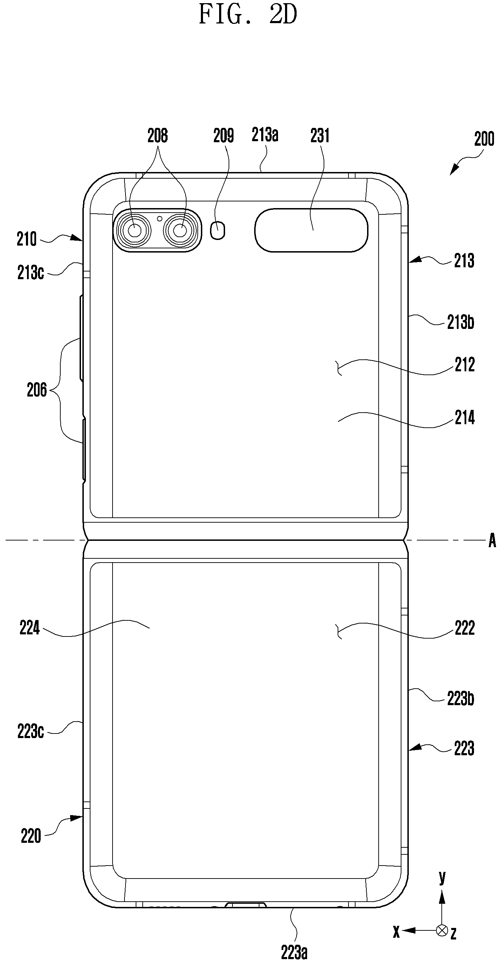

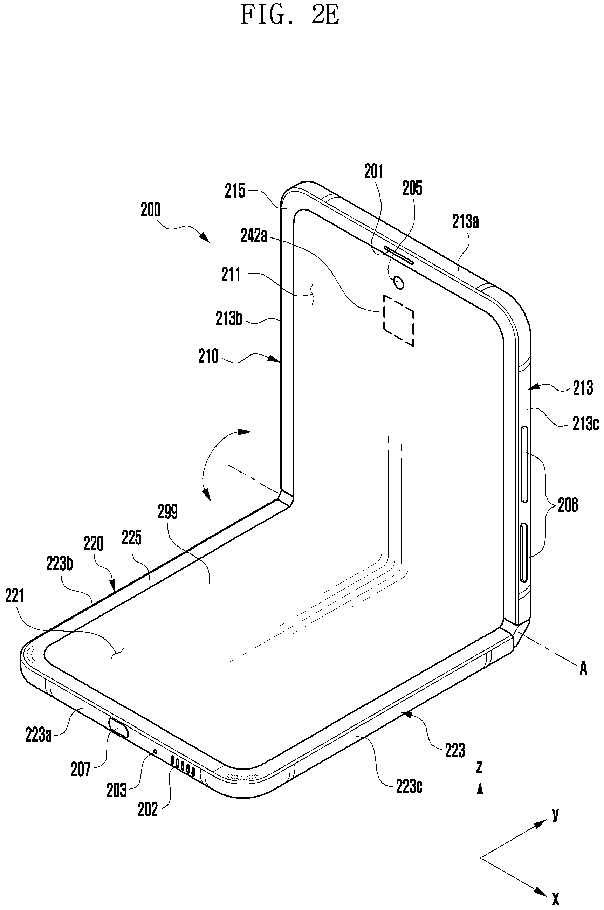

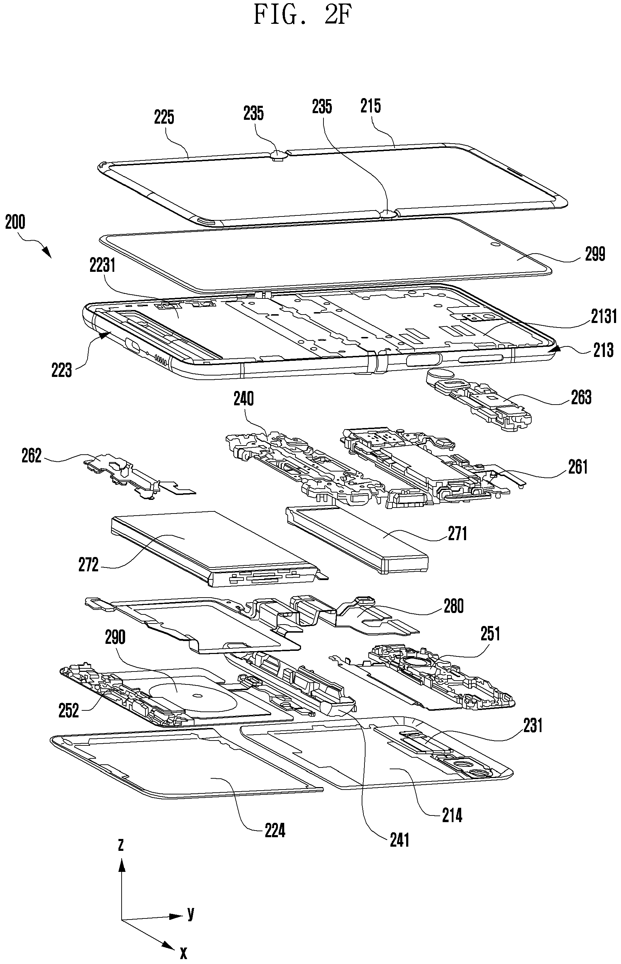

FIGS. 2A to 2F illustrate a portable electronic device 200 having an in-folding housing structure according to an embodiment. Specifically, FIGS. 2A and 2B illustrate a front view of a foldable portable electronic device (hereinafter, simply an electronic device) in an unfolded, flat, or open state, FIG. 2C illustrates a rear view of the electronic device in a folded or closed state, and FIG. 2D illustrates a rear view of the electronic device in an unfolded state, FIG. 2E illustrates the front surface in a partially folded state (alternatively, a partially unfolded state, or an intermediate state (a freestop state) between a fully folded state and a fully unfolded state, and FIG. 2F is an exploded perspective view of the electronic device.

Referring to FIGS. 2A to 2F, the portable electronic device 200 (e.g., the electronic device 101 in FIG. 1) may include a first housing 210, a second housing 220, a hinge assembly 240 connecting the first housing 210 to the second housing 220 such that the second housing 220 is rotatable relative to the first housing 210, a flexible or foldable display 299 disposed in a space formed by the foldable housings 210 and 220, and a sensor module (e.g., the sensor module 176 in FIG. 1).

The display 299 may be disposed from the first housing 210 to the second housing 220 across the hinge assembly 240. The display 299 may be divided into a first display area 211, disposed in the inner space of the first housing 210, and a second display area 221, disposed in the inner space of the second housing 220, with respect to the folding axis A. The sensor module (e.g., an illuminance sensor) may be disposed below a sensor area (or light-transmitting area) 242a of the first display area 211 when viewed from the front. The location and/or size of the sensor area 242a in the first display area 211 may be determined by the location and/or size of the illuminance sensor disposed below the sensor area. For example, the size (e.g., diameter) of the sensor area 242a may be determined based on the field of view (FOV) of the illuminance sensor. In an embodiment, the sensor area 242a may be configured to have a lower pixel density and/or lower wiring density than surroundings thereof in order to improve light transmittance. In some embodiments, the display 299 may include a protective layer 298 that includes a transparent material and protects a panel layer from external foreign matter and external impacts.

The hinge assembly 240 may be implemented in an in-folding manner such that the two display areas 211 and 221 face each other when the portable electronic device 200 switches from an unfolded state (e.g., the state in FIG. 2A) to a folded state (e.g., the state in FIG. 2C). For example, when the electronic device 200 is in the unfolded state, the two display areas 211 and 221 may face substantially the same direction. As the electronic device 200 switches from the unfolded state to the folded state, the two display areas 211 and 221 may be rotated to face each other. The hinge assembly 240 may be configured such that the foldable housings 210 and 220 have resistance against rotation. When an external force that exceeds the resistance is applied to the foldable housings 210 and 220, the foldable housing 210, 220 may be rotated.

The state of the electronic device 200 may be defined based on an angle formed between the two display areas 211 and 221. For example, the state of the electronic device 200 may be defined as an unfolded, flat, or open state when the angle between the two display areas 211 and 221 is about 180 degrees. When the angle between the two display regions 211 and 221 is between about 0 degrees and about 10 degrees, the state of the portable electronic device 200 may be defined as a folded or closed state. When the two display areas 211 and 221 form an angle greater than the angle in the folded state and smaller than the angle in the unfolded state (e.g., between about 10 degrees and 179 degrees), the state of the portable electronic device 200 may be defined as an intermediate state (in other words, a partially folded or partially unfolded state) as illustrated in FIG. 2E.

An active area in which visual information (e.g., text, image, or icon) will be displayed on the display 299 may be determined based on the state of the portable electronic device 200. For example, when the electronic device 200 is in an intermediate state, the active area may be determined to be the first display area 211 or the second display area 221. The area with relatively less movement between the first display area 211 and the second display area 221 may be determined as the active area. For example, when a user grips one housing of the electronic device 200 with one hand and opens the other housing with a finger (e.g., thumb) of the same hand or with the other hand, the electronic device 200 may switch from a folded state to an intermediate state, and the electronic device 200 may thereby determine that the displayed area of the gripped housing (e.g., the housing with relatively less movement) is the active area. When the portable electronic device 200 is in the unfolded state, the entire area (e.g., both the first display area 211 and the second display area 221) of the display 299 may be determined to be an active area.

According to various embodiments, the first housing 210 may include, in an unfolded state, a first surface (the first display area) 211 facing a first direction (e.g., a front direction) (the z-axis direction) and a second surface 212 facing a second direction (e.g., a rear direction) (the -z-axis direction) opposite to the first side 211. The second housing 220 may include, in an unfolded state, a third surface (the second display area) 221 facing the first direction (e.g., the z-axis direction) and a fourth surface 222 facing the second direction (e.g., the - z-axis direction). The electronic device 200 may be operated in such a manner that, in the unfolded state, the first surface 211 of the first housing 210 and the third surface 221 of the second housing 220 face the same first direction (e.g., the z-axis direction) and that, in the folded state, the first surface 211 and the third surface 221 face each other. The electronic device 200 may be operated such that, in the unfolded state, the second surface 212 of the first housing 210 and the fourth surface 222 of the second housing 220 face the same second direction (e.g., the -z axis direction) and in the folded state, the second surface 212 and the fourth surface 222 face opposite directions.

According to various embodiments, the first housing 210 may include a first lateral frame 213, which at least partially forms the exterior of the electronic device 200, and a first rear cover 214, which is coupled to the first lateral frame 213 and forms at least a part of the second surface 212 of the electronic device 200. According to an embodiment, the first lateral frame 213 may include a first side surface 213a, a second side surface 213b extending from one end of the first side surface 213a, and a third side surface 213c extending from the other end of the first side surface 213a. According to an embodiment, the first lateral frame 213 may be formed in an oblong (e.g., square or rectangular) shape by the first side surface 213a, the second side surface 213b, and the third side surface 213c.

A part of the first lateral frame 213 may be formed of a conductor. For example, referring to FIG. 2B, a part ⓕ of the first side surface 213a, a part ⓓ of the second side surface 213b, and a part ⓔ of the third side surface 213c may be formed of a metal material. The conductors may be electrically connected to grip sensors (not shown) adjacent thereto and disposed in the inner space of the first housing 210. A processor may measure capacitance formed between the conductor and a ground (e.g., a ground of a main printed circuit board) through the grip sensors, and may recognize, based on the measured capacitance value, that a dielectric (e.g., the finger, the palm, or the face) has been in proximity (or contact) with the first housing 210 and where the first housing 210 is in contact with the dielectric (e.g., the first side surface 213a, the second side surface 213b, or the third side surface 213c).

According to various embodiments, the second housing 220 may include a second lateral frame 223, which at least partially forms the exterior of the electronic device 200, and a second rear cover 224, which is coupled to the second lateral frame 223 and forms at least a part of the fourth surface 222 of the electronic device 200. According to an embodiment, the second lateral frame 223 may include a fourth side surface 223a, a fifth side surface 223b extending from one end of the fourth side surface 223a, and a sixth side surface 223c extending from the other end of the fourth side surface 223a. According to an embodiment, the second lateral frame 223 may be formed in an oblong shape by the fourth side surface 223a, the fifth side surface 223b, and the sixth side surface 223c.

A part of the second lateral frame 223 may be formed of a conductor. For example, referring to FIG. 2B, a part ⓑ of the fourth side surface 223a, a part ⓐ of the fifth side surface 223b, and a part ⓒ of the sixth side surface 223c may be formed of a metal material. The conductors may be electrically connected to a grip sensor (not shown) adjacent thereto and disposed in the inner space of the second housing 220. The processor may measure capacitance formed between the conductor and the ground (e.g., the ground of the main printed circuit board) through the grip sensor and may recognize, based on the measured capacitance value, that a dielectric has been in proximity to (or contact with) the second housing 220 and where the second housing 220 is in contact with the dielectric (e.g., the fourth side surface 223a, the fifth side surface 223b, or the sixth side surface 223c).

According to various embodiments, the pair of housings 210 and 220 are not limited to the illustrated shapes and combinations, and may be implemented by combinations and/or coupling of other shapes or components. For example, the first lateral frame 213 may be integrally formed with the first rear cover 214, and the second lateral frame 223 may be integrally formed with the second rear cover 224.

According to various embodiments, the first rear cover 214 and the second rear cover 224 may be formed by at least one or a combination of at least two of, for example, coated or colored glass, ceramic, polymer, or metal (e.g., aluminum, stainless steel (STS), or magnesium)

According to various embodiments, the electronic device 200 may include a first protective cover 215 (e.g., a first protective frame or a first decorative member) coupled along an edge of the first housing 210. The electronic device 200 may include a second protective cover 225 (e.g., a second protective frame or a second decorative member) coupled along an edge of the second housing 220. According to an embodiment, the first protective cover 215 and the second protective cover 225 may be formed of a metal or a polymer material.

According to various embodiments, the electronic device 200 may include a sub-display 231 disposed separately from the display 299. According to an embodiment, the sub-display 231 may be disposed to be at least partially exposed on the second surface 212 of the first housing 210 so as to display state information of the electronic device 200 when the electronic device 200 is folded. According to an embodiment, the sub-display 231 may be disposed to be visible from the outside through at least a partial area of the first rear cover 214. In some embodiments, the sub-display 231 may be disposed on the fourth surface 222 of the second housing 220. In this case, the sub-display 231 may be disposed to be visible from the outside through at least a partial area of the second rear cover 224.

According to various embodiments, the electronic device 200 may include at least one among an input device 203, sound output devices 201 and 202, camera modules 205 and 208, a key input device 206, a connector port 207, and a sensor module (not shown). In an embodiment, the sensor module (e.g., the sensor module 176 in FIG. 1) and the camera 205 may be disposed below the display 299 when viewed from the front.

According to various embodiments, the electronic device 200 may be operated to maintain an intermediate state through the hinge assembly 240. In this case, the electronic device 200 may control the display 299 such that different contents are displayed on a display area corresponding to the first surface 211 and a display area corresponding to the third surface 221.

Referring to FIG. 2F, the electronic device 200 according to various embodiments may include the first lateral frame 213, the second lateral frame 223, and the hinge assembly 240 rotatably connecting the first lateral frame 213 and the second lateral frame 223 to each other. According to an embodiment, the electronic device 200 may include a first support plate 2131 extending at least partially from the first lateral frame 213, and a second support plate 2231 extending at least partially from the second lateral frame 223. According to an embodiment, the first support plate 2131 may be integrally formed with the first lateral frame 213 or structurally coupled to the first lateral frame 213. Similarly, the second support plate 2231 may be integrally formed with the second lateral frame 223 or structurally coupled to the second lateral frame 223. According to an embodiment, the electronic device 200 may include the display 299 disposed to be supported by the first support plate 2131 and the second support plate 2231. According to an embodiment, the electronic device 200 may include the first rear cover 214 coupled to the first lateral frame 213 and providing a first space between the first rear cover 214 and the first support plate 2131, and the second rear cover 224 coupled to the second lateral frame 223 and providing a second space between the second rear cover 224 and the second support plate 2231. In some embodiments, the first lateral frame 213 and the first rear cover 214 may be integrally formed. In some embodiments, the second lateral frame 223 and the second rear cover 224 may be integrally formed. According to an embodiment, the electronic device 200 may include the first housing 210 provided by the first lateral frame 213, the first support plate 2131, and the first rear cover 214. According to an embodiment, the electronic device 200 may include the second housing 220 provided by the second lateral frame 223, the second support plate 2231, and the second rear cover 224.

Although not shown, the hinge assembly 240 may include a first arm structure coupled to the first housing 210 (e.g., the first support plate 2131), a second arm structure coupled to the second housing 220 (e.g., the second support plate 2231), and a detent structure physically contacting the first arm structure and the second arm structure such that the first housing 210 and the second housing 220 have resistance to rotation. The foldable housings 210 and 220 may have resistance to rotation by a contact force of the detent structure (e.g., a force pushing the first arm structure and the second arm structure).

According to various embodiments, the electronic device 200 may include a first substrate assembly 261 (e.g., a main printed circuit board), a camera assembly 263, a first battery 271, or a first bracket 251, which is disposed in the first space between the first lateral frame 213 and the first rear cover 214. According to an embodiment, the camera assembly 263 may include multiple cameras (e.g., the camera modules 205 and 208 in FIGS. 2A and 2C), and may be electrically connected to the first substrate assembly 261. According to an embodiment, the first bracket 251 may provide a support structure and improved rigidity for supporting the first substrate assembly 261 and/or the camera assembly 263. According to an embodiment, the electronic device 200 may include a second substrate assembly 262 (e.g., a sub printed circuit board), an antenna 290 (e.g., a coil member), a second battery 272, or a second bracket 252, which is disposed in the second space between the second lateral frame 223 and the second rear cover 224. According to an embodiment, the electronic device 200 may include a wiring member 280 (e.g., a flexible printed circuit board (FPCB)) which is disposed to extend from the first substrate assembly 261, across the hinge assembly 240, to multiple electronic components (e.g., the second substrate assembly 262, the second battery 272, or the antenna 290) disposed between the second lateral frame 223 and the second rear cover 224, and provides electrical connectivity.

According to various embodiments, the electronic device 200 may include a hinge cover 241 that supports the hinge assembly 240 and is disposed to be exposed to the outside when the electronic device 200 is folded, and to be invisible from the outside by being moved into the first and second spaces when the electronic device 200 is unfolded.

According to various embodiments, the electronic device 200 may include the first protective cover 215 coupled along an edge of the first lateral frame 213. According to an embodiment, the electronic device 200 may include the second protective cover 225 coupled along an edge of the second lateral frame 223. In the display 299, the edge of the first display area 211 may be protected by the first protective cover 215. The edge of the second display area 221 may be protected by the second protective cover 225. Protective caps 235 may be disposed in an area corresponding to the hinge assembly 240 to protect bending parts in the edge of the display 299.

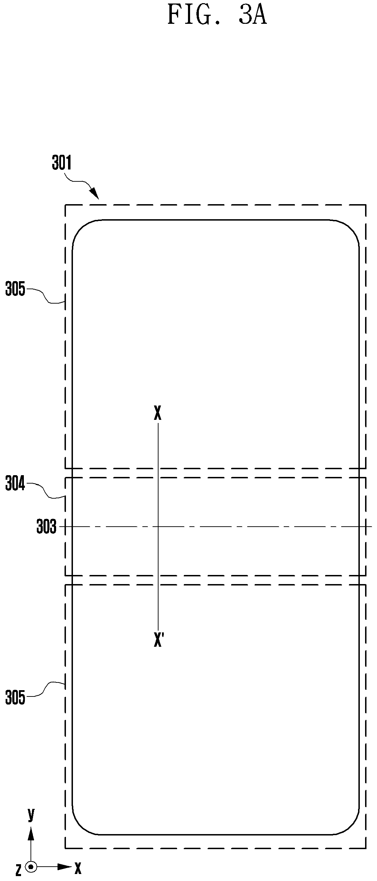

FIG. 3A is a plan view illustrating a flexible display 300 of an electronic device according to various embodiments of the disclosure.

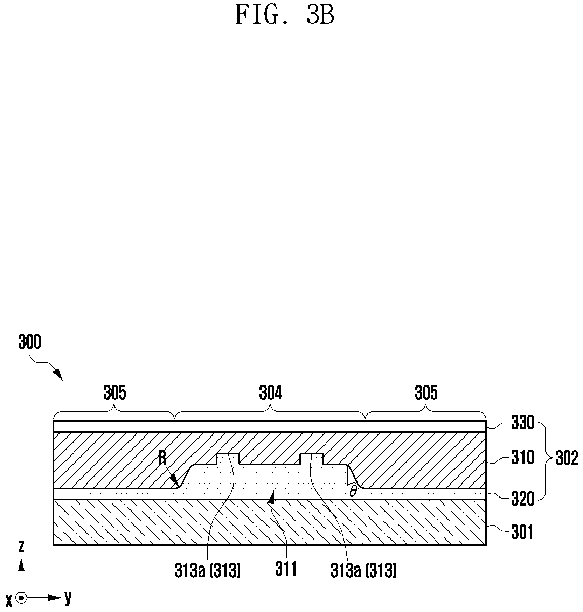

FIG. 3B is a cross-sectional view illustrating the flexible display 300 according to various embodiments.

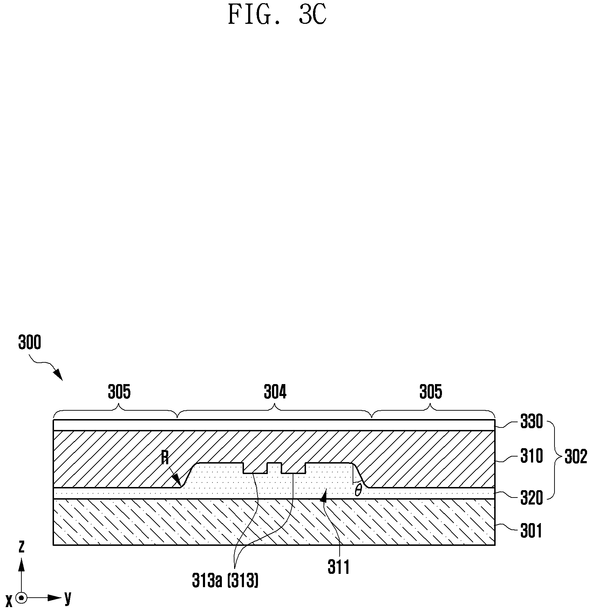

FIG. 3C is a cross-sectional view illustrating the flexible display 300 according to various embodiments.

FIGS. 3B and 3C are cross-sectional views taken in the X-X' direction in FIG. 3A.

Referring to FIG. 3A, a flexible display 300 (e.g., the display 299 in FIGS. 2A to 2F) of an electronic device (e.g., the electronic device 101 in FIG. 1 or the foldable electronic device 200 in FIGS. 2A to 2F) may include a first part 304 and a second part 305 located in an area other than the first part 304. The first part 304 may be a part where the flexible display 300 can be bent and unbent. For example, the flexible window 302 may be bent and unbent about a bending axis 303.

Referring to FIGS. 3B and 3C, the flexible display 300 may include a flexible display panel 301 and a flexible window 302. The flexible window 302 may be a member disposed in an image display direction (e.g., the z-axis direction) of the flexible display panel 301 to protect the flexible display panel 301. In various embodiments, the flexible window 302 may include a transparent layer(e.g. glass layer 310) having a transparent material. The transparent material may include glass and/or transparent polymer. The glass layer 310 may include, for example, a tempered glass material that has been strengthened by a thermal or chemical method. The tempered glass material may have high hardness and stiffness to effectively protect the flexible display panel 301 from external damage, such as penetration and crushing. In various embodiments, the glass layer 310 may include a first part 304, which can be bent and unbent, and a second part 305, which cannot be bent. In various embodiments, the glass layer 310 of the second part 305 may have a thickness of 30 micrometers or more, and thus may have high resistance to external forces, such as writing by a stylus pen or dropping of the stylus pen thereon.

The first part 304 of the flexible window 302 may have a first recess 311 formed to assist bending of the first part 304. The first recess 311 may be formed, for example, in the glass layer 310. The first recess 311 may be formed by recessing a surface (e.g., a surface facing an opposite direction to the z-axis) of the glass layer 310 of the first part 304, and may be a part having a thickness less than the thickness of the second part 305. By having a smaller thickness than the second part 305, the first recess 311 may have lower stiffness and higher flexibility around the bending axis 303 than the second part 305, and thus may allow the first part 304 of the flexible window 302 to be easily bent and unbent about the bending axis 303 during bending and unbending of the flexible display 300. In various embodiments, the first recess 311 may have an aspect ratio (e.g., a dimension in the y-direction and a dimension in the z-direction) of 5:1 or greater.

In various embodiments, the first recess 311 may have a tapered shape that forms an angle with respect to the thickness direction (the z-axis direction). The tapered shape may smooth out the change in thickness from the second part 305 to the first recess 311. Thus, optical distortion or scattering that may be caused by the thickness difference between the second part 305 and the first recess 311 may be mitigated, thereby improving the image quality of the flexible display 300. In various embodiments, corners of the first recess 311 may have a round shape having the radius of curvature, R. Since the corner has a round shape, stress concentration on the corners of the first recess 311 may be mitigated.

A reinforcement part 313 may be formed in the first part 304 of the flexible window 302. The reinforcement part 313 may be a part that reinforces the first part 304 by extending from the first part 304 in the direction of the bending axis 303 (e.g., in the x direction). Referring to FIG. 3B, in various embodiments, the reinforcement part 313 may include a rib 313b protruding from the first part 304. Referring to Figure 3C, in various embodiments, the reinforcement part 313 may include a reinforcement groove 313a recessed from a surface of the first part 304. FIGS. 3B and 3C illustrate embodiments in which two reinforcement parts 313 are formed, but the disclosure is not limited thereto, and it will be obvious to those skilled in the art that one or more reinforcement part 313 may be formed to reinforce the first part 304 against various stresses applied to the flexible window 302, as described below.

In various embodiments, the reinforcement part 313 may be disposed on the face of the glass layer 310 so as to be close to or distant from the center of the first part 304. For example, referring to FIG. 3B, the reinforcement groove 313a may be disposed at a location relatively distant from the center of the first part 304. Referring to FIG. 3C, the rib 313c may be disposed at a location relatively close to the center of the first part 304. An effect resulting therefrom will be described later.

In various embodiments, the flexible window 302 may include a transparent polymer layer 320. The transparent polymer layer 320 may be a member that fills the space between corrugations formed by locating the first recess 311 and the reinforcement part 313 of the first part 304. Transparent polymer may include, for example, an acrylic-based resin such as acrylic urethane or poly-methyl-methacrylate (PMMA) and/or a material such as siloxane. The refractive index of the transparent polymer layer 320 may be equal or similar to the refractive index of the glass layer 310. For example, the refractive index of the transparent glass may differ by less than 0.2 refraction index unit (RIU) from the refractive index of the glass layer 310. Thus, the flexible window 302 including the transparent polymer layer 320 may prevent and/or minimize degradation of image quality due to refraction or scattering of light caused by the corrugations formed by the first recess 311 and the reinforcement part 313 in the glass layer 310.

In various embodiments, the flexible window 302 may include a film layer 330. The film layer 330 may be a film made of a polymer material having high hardness and flexibility to protect the surface of the glass layer 310 from impact and scratches. The material of the film layer 330 may include, for example, colorless polyimide (CPI), PET, or transparent polyurethane. Although not shown, in various embodiments, the film layer 330 may be attached to the surface of the flexible window 302 by means of a member such as a pressure-sensitive adhesive (PSA).

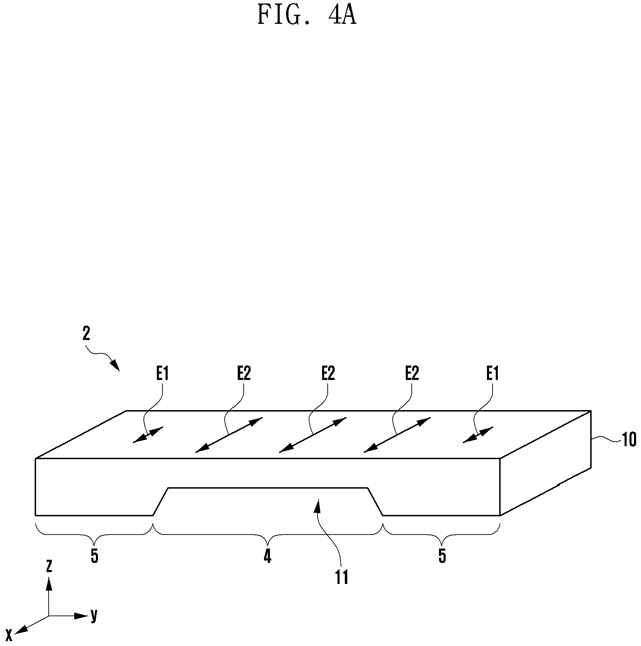

FIG. 4A is a schematic diagram illustrating the expansion of each part due to a stress applied during tempering of a flexible window 2 according to a comparative example.

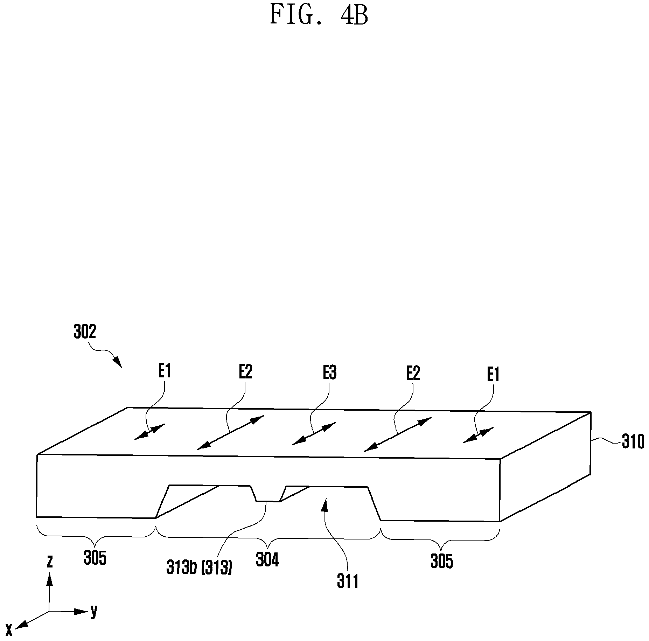

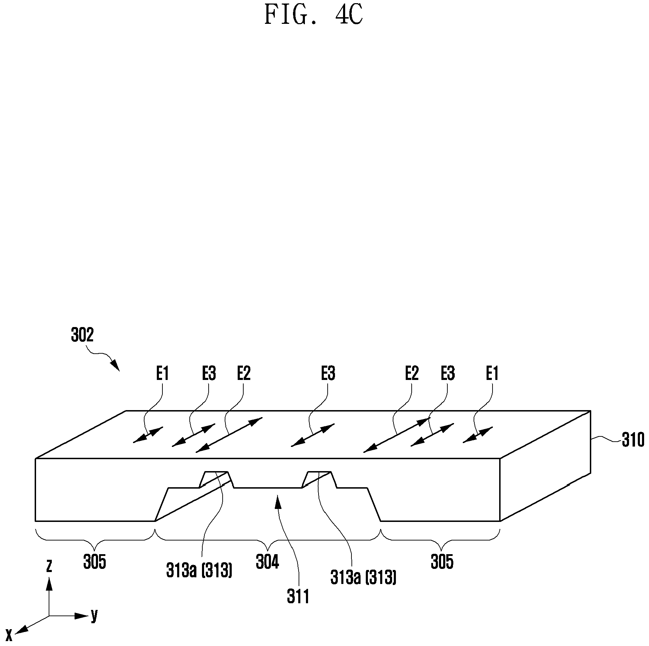

FIGS. 4B and 4C are schematic views illustrating the expansion of each part of a stress applied during tempering of the flexible window 302 according to embodiments of the disclosure.

The flexible window 2 according to the comparative example in FIG. 4A is a flexible window 2 in which a first recess 11 is disposed in a first part 4 for flexibility of the first part but a reinforcement part is not disposed in the first recess 11.

Referring to FIG. 4A, the flexible window 2 according to the comparative example may be subjected to disproportionate strains E1 and E2 due to volume changes caused by thermal or chemical tempering, due to a thickness difference between and a second part 5 and the first recess 11 formed for the flexibility of the first part 4. For example, in a thicker flat section 5, the effect of volume change due to ionic infiltration or thermal shrinkage in the chemical tempering process is relatively small in the total volume, and a low strain E1 may occur. The thin first recess 11 is relatively more affected by a volume change and may therefore have a large strain E2. Due to the difference in strain described above, warpage may occur in the first recess 11 constrained by the second part 5. For example, warpage may occur in the first recess 1 1 along the x-axis direction.

Referring to FIB. 4B and 4C, the flexible window 302 according to embodiments of the disclosure may reduce warpage in the x-axis direction as the reinforcement part 313 located in the first recess 311 provides additional stiffness to the first recess 311. Thus, the occurrence of warpage due to a thickness difference and a strain disproportion may be reduced.

In addition, referring to FIG. 4B, since a part where a rib is disposed in the first recess 311 is relatively thick compared with the first recess 311, the volume change in the part where the rib is disposed may be smaller than those of other parts of the first recess 311, and thus the strain E3 in that part may also be relatively small. Therefore, the rib may mitigate strain difference due to a difference in the volume change of the first recess 311.

In addition, referring to FIG. 4C, a part where the reinforcement groove 313a is disposed in the first recess 311 is the periphery of the first recess 311, and may be disposed so that the distribution of strain increases stepwise from E1 of the second part 305 to E2 of the reinforcement groove 313a via the strain E3 of the first recess 311, thereby mitigating the occurrence of warpage due to a sudden change in strain such as the comparative example in FIG. 4a.

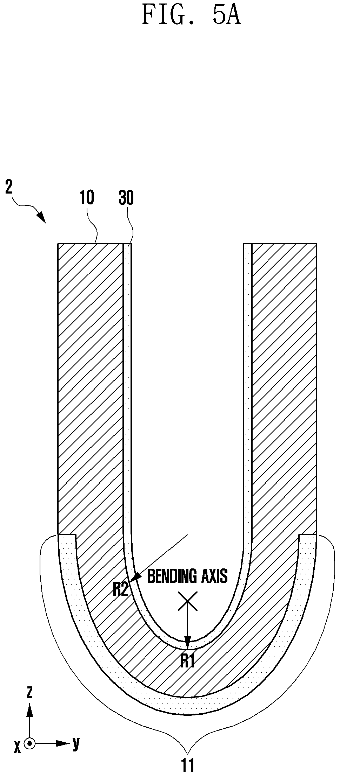

FIG. 5A is a side view illustrating the bent state of the flexible window 2 according to a comparative example.

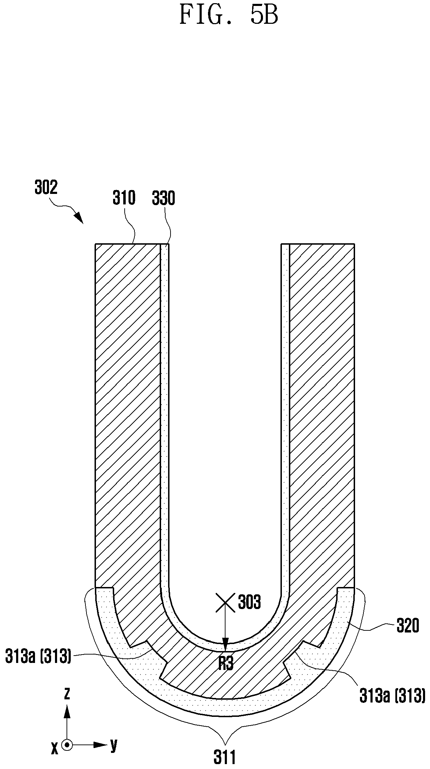

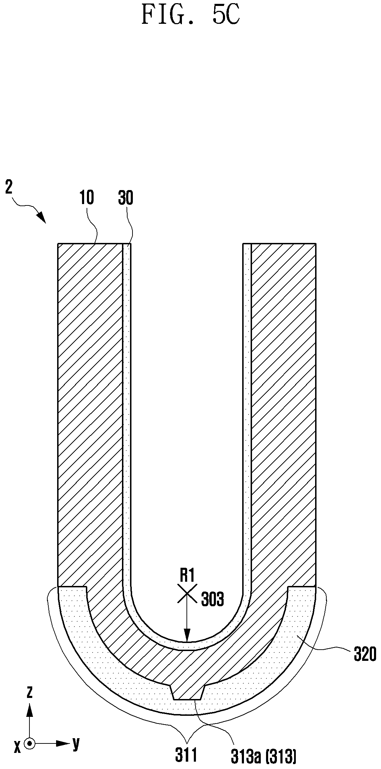

FIGS. 5B and 5C are side views illustrating the bent state of the flexible window 302 according to embodiments of the disclosure.

The flexible window 2 according to the comparative example in FIG. 5A is a flexible window 2 in which the first recess 11 is disposed in the first part 4 for flexibility of the first part 4 but the reinforcement part 313 is not located in the first recess 11.

Referring to FIG. 5A, when the flexible window 2 according to the comparative example is bent along a bending axis, the bending moment of the first part 4 is concentrated in the center of the first recess 11, and thus the radius of curvature R1 of the central part of the first part 4 may be smaller than the radius of curvature R2 of the peripheral part thereof. The smaller radius of curvature R1 may cause excessive strain in the film layer 30 disposed on the surface of glass, thereby causing whitening of the polymer material of the film layer 30 by plastic deformation, or causing the film layer 30 to detach from the glass layer 10.

Referring to FIG. 5B, according to an embodiment of the disclosure, the reinforcement groove 313a may be spaced apart from the center of the first part 304. A part of the first part 304 where the reinforcement groove 313a is formed may have relatively low stiffness with respect to a bending moment about the bending axis 303. Therefore, the central part of the first part 304 may have relatively high stiffness. Since the stiffness of the central part is relatively high and the stiffness of the part where the reinforcement groove 313a is disposed is relatively low, the bending moment may be distributed from the central part of the first part 304 to the periphery where the reinforcement groove 313a is disposed, compared with the comparative example in FIG. 5A. Therefore, the radius of curvature R3 of the central part of the first part 304 may be increased compared with the radius of curvature R1 in the comparative example, and whitening and detachment of the film layer 330 due to the concentration of strain on the central part may be prevented or reduced.

Referring to FIG. 5C, according to an embodiment of the disclosure, the rib may be disposed in or adjacent to the central part of the first part 304. The part where the rib is disposed may have relatively higher stiffness with respect to the bending moment about the bending axis 303 than other parts of the first part 304. Therefore, the bending moment may be distributed from the central part of the first part 304 to the periphery thereof, and thus whitening or detachment of the film layer 330 due to the concentration of strain on the central part may be prevented and reduced as described above.

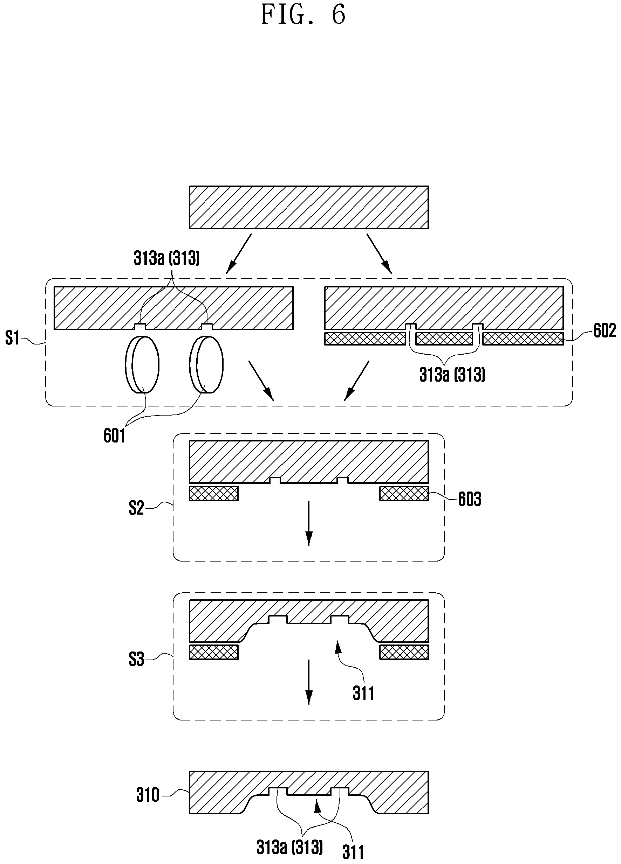

FIG. 6 is a schematic diagram illustrating a manufacturing process of the flexible window 302 according to various embodiments.

Referring to FIG. 6, the flexible window 302 according to various embodiments reinforcement part may be manufactured by a reinforcement part processing operation S1, a masking operation S2, and an etching operation S3.

The reinforcement part processing operation S1 may be an operation of forming the reinforcement part 313, such as the reinforcement groove 313a, on the surface of the glass layer 310. A mechanical processing means, such as a grinder, and/or a chemical processing means using a masking and etching solution may be used as a means for forming the reinforcement groove 313a.

The masking operation S2 may be an operation of locating a mask, which exposes an area corresponding to the first recess 311, on the surface of the glass layer 310 on which the reinforcement part 313 is processed. The mask may include, for example, a masking film, print, or photoresist.

The etching operation S3 may be an operation of etching the area exposed by the mask to form the first recess 311. The etching may be performed by immersing the glass layer 310 in an etching solution and/or by spraying an etching solution onto the surface of the glass layer 310. The etching solution may include an acidic etching solution and/or a basic etching solution containing components such as hydrofluoric acid or fluoride.

When etching, the etching solution may etch not only the first recess 311 but also the reinforcement part 313. Accordingly, in the reinforcement part processing operation S 1, the reinforcement part 313 may be processed in consideration of the etching in the etching operation S3. For example, in the reinforcement part processing operation S1, the reinforcement groove 313a may be formed to have a size smaller than the final size of the reinforcement groove 313a. Although not shown, it will be obvious to those skilled in the art that in the reinforcement part processing operation S1, a reinforcement rib 313b may be formed to have a size larger than the final size of the reinforcement rib 313b.

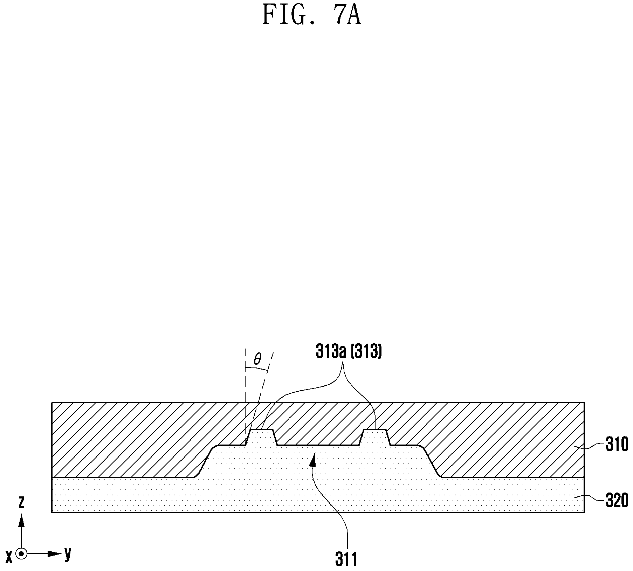

FIGS. 7A to 7C are cross-sectional views illustrating the flexible window 302 according to various embodiments.

Referring to FIG. 7A, the reinforcement part 313 formed in the first part 304 of the flexible window 302 may have a tapered shape in the thickness direction (the z-axis direction). The taper may be a shape in which the width of the reinforcement part 313 gradually decreases in a direction away from the surface of the first recess 311. Since the reinforcement part 313 has a tapered shape, the difference in thickness between the reinforcement part 313 and other parts of the first recess 311 becomes gradual, so degradation of image quality due to refraction or scattering occurring in the reinforcement part 313 may be prevented or reduced.

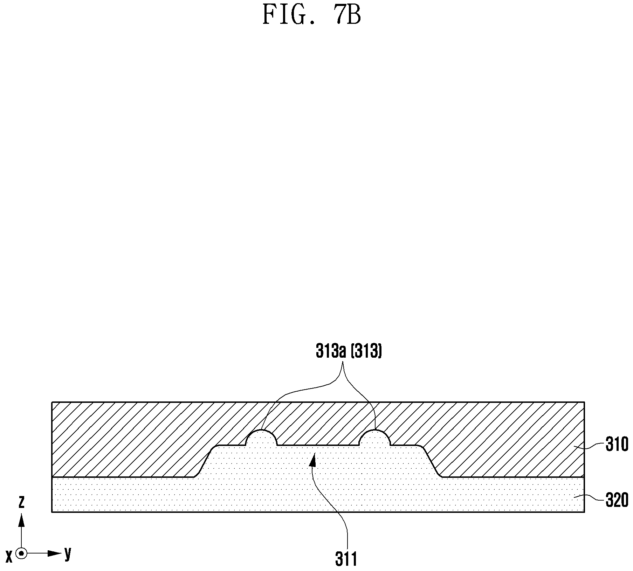

Referring to FIG. 7B, the reinforcement part 313 formed in the first part 304 of the flexible window 302 may have a curved surface shape, for example, a semicircular shape. The curved surface shape may prevent stress from being concentrated on the corners of the reinforcement part 313.

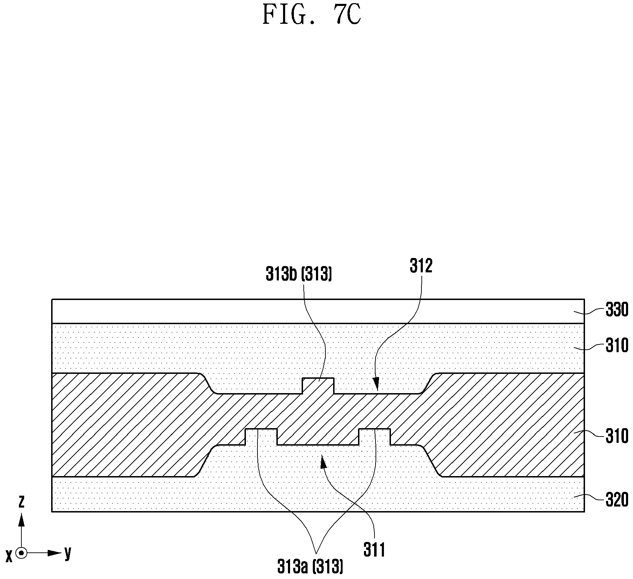

Referring to FIG. 7C, the flexible window 302 may include a second recess 312 formed on a surface opposite to the first recess 311 with respect to the thickness direction (e.g., the z-axis direction) of the glass layer 310. Since the second recess 312 is included, the thickness of the first part 304 may be easily reduced without making the aspect ratio of the first recess 311 excessively small (e.g., less than 5:1). Accordingly, any reduction in visibility or concentration of stress on the corners of the first recess 311 that may be caused by an excessively large aspect ratio of the first recess 311 may be reduced. The second recess 312 may include a reinforcement part 313 for further reinforcing the first part 304. Although FIG. 7A illustrates an embodiment in which the reinforcement part 313 is a rib 313b, it will be obvious to those skilled in the art that an embodiment in which the reinforcement groove 313a is formed in the second recess 312 is also possible. With regard to the reinforcement part 313 formed in the second recess 312, reference may be made to the description of the reinforcement part 313 formed in the first recess 311 insofar as the description is not contradictory.

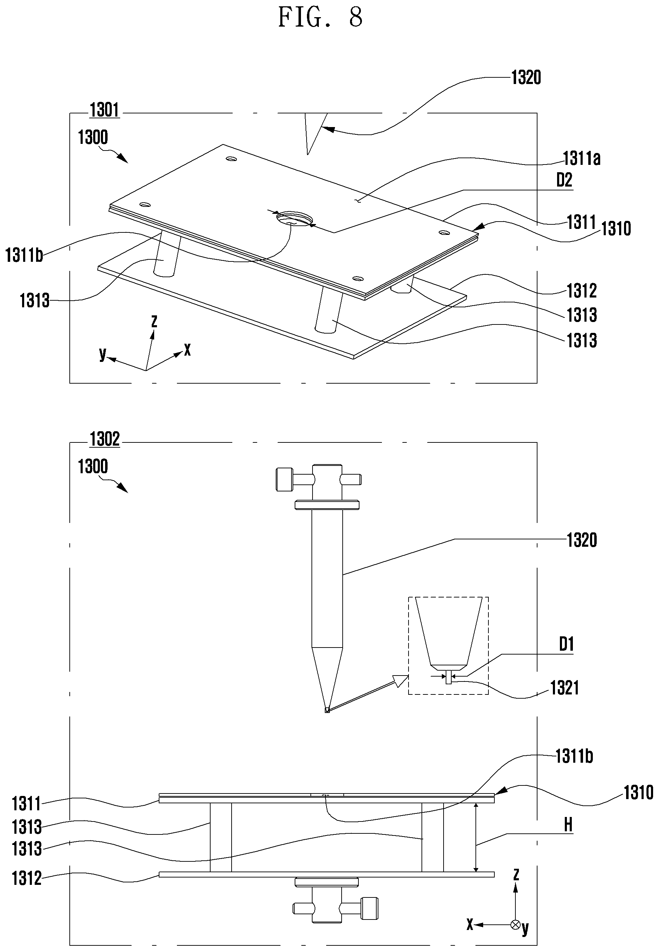

FIG. 8 is a perspective view 1301 of a test device 1300 for first evaluation, second evaluation, and third evaluation, and a view 1302 showing the test device 1300 according to an embodiment.

Referring to FIG. 8, in an embodiment, the test device 1300 may include a clamping device (e.g., a manual clamping fixture) 1310 and a probe (e.g., a penetration probe) 1320. A flexible material (e.g., a flexible film and/or a laminate) (e.g., the glass layer 310 in FIG. 3, or a laminate including the glass layer 310) may be disposed on the clamping device 1310. The probe 1320 may be implemented to be linearly movable with respect to the clamping device 1310. The probe 1320 may be moved linearly to apply a load to the flexible material disposed on the clamping device 1310. When the probe 1320 breaks the flexible material, the load (e.g., a breaking load) may be detected by a detector (e.g., sensor) connected to the probe 1320.

According to an embodiment, the clamping device 1310 may include a first plate 1311, a second plate 1312, and multiple supports 1313.

According to an embodiment, the first plate 1311 may be a surface plate. A flexible material to be tested (e.g., the glass layer 310 in FIG. 3, or a laminate including the glass layer 310) may be disposed on the first plate 1311. The first plate 1311 may include a support surface 1311a on which the flexible material to be tested is disposed. The support surface 1311a of the first plate 1311 may be substantially planar. The first plate 1311 may include an opening 1311b corresponding to the probe 1320. The opening 1311b may reduce or prevent the effect of the first plate 1311 on detection of the strength of the flexible material. The opening 1311b may prevent the first plate 1311 from interfering with the linear movement of the probe 1320.

According to an embodiment, the second plate 1312 may be spaced apart from the first plate 1311 in a direction in which the probe 1320 is moved linearly to press the flexible material (e.g., the glass layer 310 in FIG. 3 or a laminate including the glass layer 310). The space between the first plate 1311 and the second plate 1312 may prevent the clamping device 1310 from interfering with the linear movement of the probe 1320. The multiple supports 1313 may be disposed between the first plate 1311 and the second plate 1312. The multiple supports 1313 may connect the first plate 1311 to the second plate 1312. The second plate 1312 may be coupled to a body (not separately shown) included in the test device 1300, and the first plate 1311 may be supported by the multiple supports 1313 and spaced apart from the second plate 1312 coupled to the body. The body of the test device 1300 is a substantial support body that stably supports elements such as the probe 1320 and the second plate 1312, and may reduce vibration or shaking during operation of the test device 1300.

According to an embodiment, the glass layer 310 in FIG. 3 or the laminate including the glass layer 310 may be disposed on the support surface 1311a of the first plate 1311. According to an embodiment, the probe 1320 may include a pen input device (e.g., an electronic pen, a digital pen, or a stylus pen). The pen input device may be disposed on the test device 1300 while standing in a direction substantially perpendicular to the support surface 1311a of the first plate 1311. When the test device 1300 is driven, a pen tip 1321 of the pen input device may press the glass layer 310 (see FIG. 3) disposed on the first plate 1311. It may be understood that moving the vertically upright pen input device in the test device 1300 to apply a load to the glass layer 310 (see FIG. 3) is at least similar to a situation in which a user drops the pen input device, or a situation in which a user performs touch input using the pen input device.

According to an embodiment, the pen input device may substantially weigh about 5.6 grams.

According to an embodiment, the diameter D1 of the pen tip 1321 included in the pen input device may be substantially about 0.3 mm.

According to an embodiment, the pen tip 1321 of the pen input device may be a ball tip made of tungsten carbide. The ball tip may be provided with a curved surface having a convex end.

According to various embodiments, the probe 1320 may be provided as an object that can substantially replace the pen input device.

According to an embodiment, the test device 1300 may follow the ASTM F1306-16 standard for evaluating puncture resistance of a flexible material in relation to the third evaluation. The probe 1320 may be provided in accordance with the ASTM F1306-16 standard. According to the ASTM F1306-16 standard, the support surface 1311a of the first plate 1311 may have a surface roughness of substantially about 200 µm. According to the ASTM F1306-16 standard, the diameter D2 of the opening 1311b of the first plate 1311 may be substantially about 35 mm. In accordance with the ASTMF1306-16 standard, the distance H that the first plate 1311 and the second plate 1312 are spaced apart from each other in the linear direction of travel of the probe 1320 may be substantially about 76 mm.

According to an embodiment, the first evaluation and the second evaluation may be substantially performed by the test device 1300 according to the ASTM F1306-16 standard.

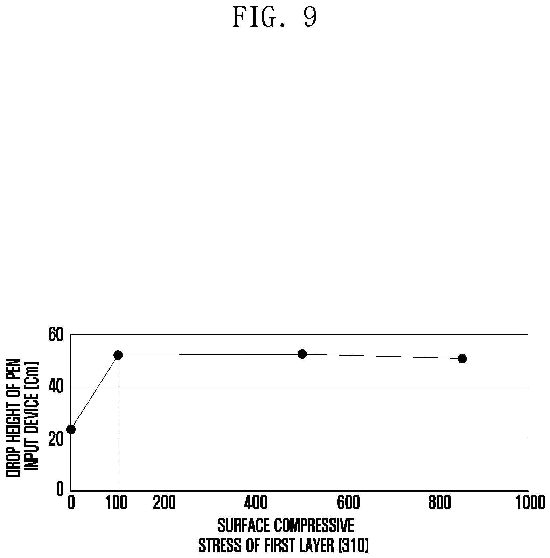

FIG. 9 is a graph showing a minimum surface compressive stress that the glass layer 310 (see FIG. 3) must have to substantially prevent breakage of the glass layer 310 depending on the drop height of a pen input device according to an embodiment.

Referring to FIG. 9, in an embodiment, the glass layer 310 may have a thickness of substantially about 0.14 mm or less than 0.14 mm. In order to reduce or prevent breakage of the glass layer 310 when a dropped pen input device impacts the glass layer 310, the glass layer 310 may be implemented to have a compressive strength capable of withstanding a surface compressive stress of about 100 MPa or greater than 100 MPa.

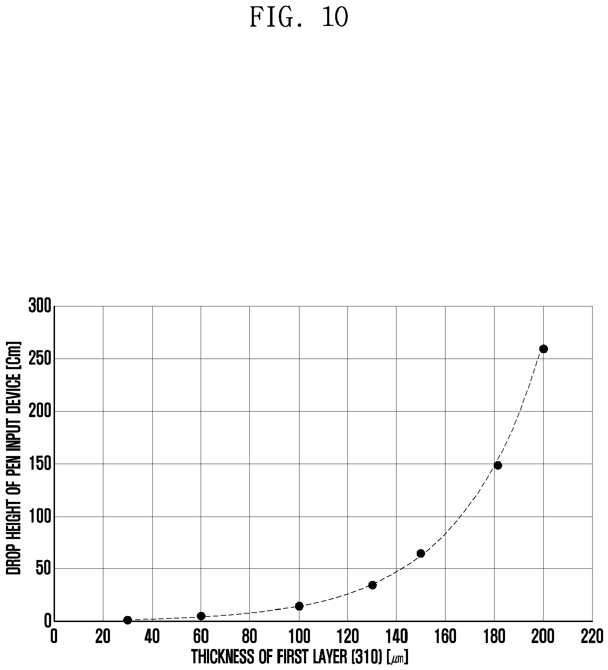

FIG. 10 is a graph showing the drop height of a pen input device that causes breakage of the glass layer 310 depending on a thickness of the glass layer 310 as a first evaluation of a laminate including the glass layer 310 in FIG. 3 according to an embodiment.

According to an embodiment, the laminate including the glass layer 310 in FIG. 3 may include the glass layer 310, a flexible display (e.g., the display 299 in FIG. 2F), and an adhesive material (e.g., the impact absorption layer) between the glass layer 310 and the flexible display.

Referring to FIG. 10, as the thickness of the glass layer 310 (see FIG. 3) included in the laminate increase, the drop height of the pen input device that causes the glass layer 310 to break may also increase. In an embodiment, the thickness of the glass layer 310 may be limited to a value that allows an electronic device (e.g., the electronic device 200 in FIG. 2A) to be bent with reduced bending stress without breakage when switching from an unfolded state to a folded state. In an embodiment, the thickness of the glass layer 310 may be limited to a value that reduces curvature and the radius of curvature as much as possible without breakage (or with reduced bending stress) when bent.

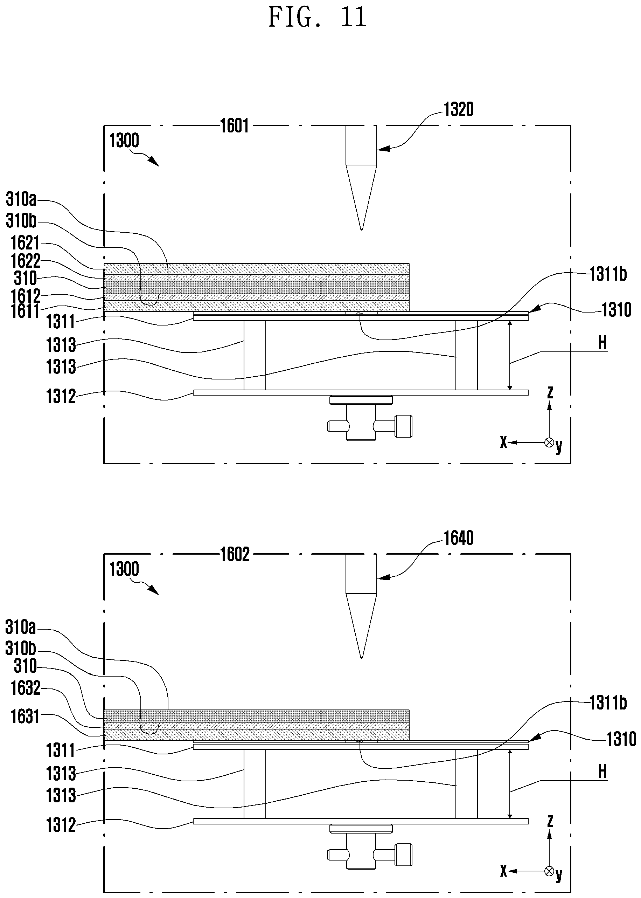

FIG. 11 is a view 1601 illustrating the test device 1300 and the glass layer 310 in conjunction with a first evaluation, and a view 1602 illustrating the test device 1300 and the glass layer 310 in conjunction with a second evaluation according to an embodiment.

Referring to FIG. 11, in the first evaluation using the test device 1300, a first protective film 1611 made of polymer may be disposed on (e.g., attached to) one surface 310a of the glass layer 310 by means of a first adhesive material (or first bonding material) 1612. In the first evaluation using the test device 1300, a second protective film 1621 made of polymer is may be disposed on (e.g., attached to) the other side 310b of the glass layer 310 by means of a second adhesive material (or a second bonding material) 1622. The first protective film 1611 and the second protective film 1621 may be, for example, polyethylene terephthalate (PET) having a thickness of substantially about 50 µm. The first adhesive material 1612 and the second adhesive material 1622 may be, for example, a pressure sensitive adhesive (PSA) having a thickness of substantially about 25 µm or less than about 25 µm.

According to an embodiment, in the second evaluation using the test device 1300, a protective film 1631 made of polymer may be disposed on (e.g., attached to) the bottom surface 310b of the glass layer 310 by means of an adhesive material (or a bonding material) 1632. The protective film 1631 may be, for example, PET having a thickness of substantially about 200 µm. The adhesive material 1632 may be, for example, PSA having a thickness of about 10 µm, or less than 10 µm. In an embodiment, in the second evaluation using the test device 1300, a protective film (e.g., a urethane jig) (not separately shown) of Hs30 hardness may be located to cover the bottom surface 310b of the glass layer 310.

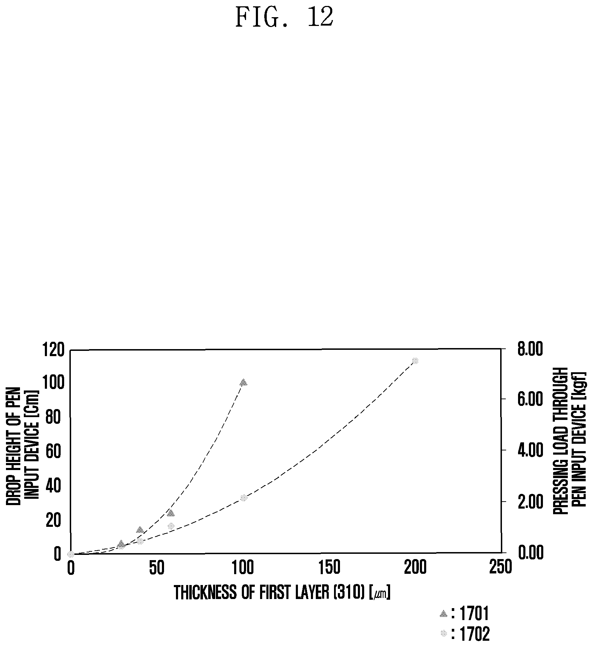

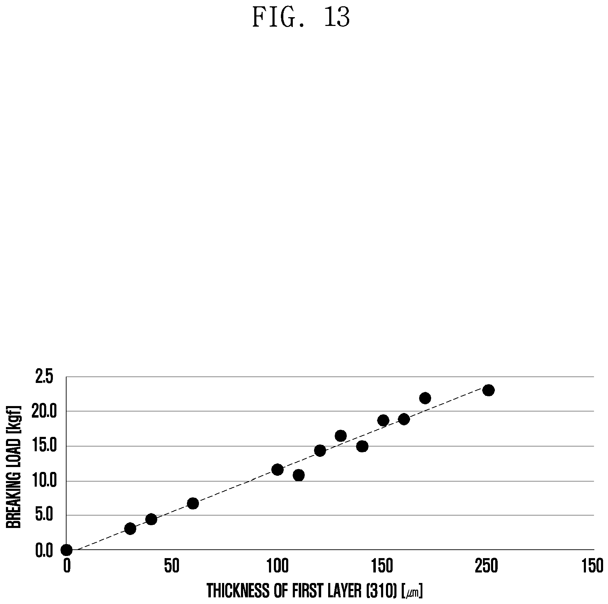

FIG. 12 is a graph 1701 showing the drop height of a pen input device (e.g., the probe 1320 in FIG. 8) that causes breakage of the glass layer 310 (see FIG. 3) depending on the thickness of the glass layer 310 as a result of the first evaluation using the test device 1300 (see FIG. 8), and a graph 1702 showing a pressing load through the pen input device that causes breakage of the glass layer 310 depending on the thickness of the glass layer 310 as a result of the second evaluation using the test device, according to an embodiment. FIG. 13 is a graph showing a breaking load depending on the thickness of the glass layer 310 as a result of the third evaluation using the test device 1300 (see FIG. 8) (e.g., a puncture resistance evaluation based on the ASTM F1306-16 standard), according to an embodiment.

According to an embodiment, in view of the result of the first evaluation disclosed in FIG. 12, the glass layer 310 (see FIG. 3) may be implemented such that the drop height of the pen input device which causes breakage of the glass layer 310 (see FIG. 3) is about 6 cm or more than 6 cm.

According to an embodiment, in view of the result of the second evaluation disclosed in FIG. 12, the glass layer 310 may be implemented such that the pressing load through the pen input device which causes breakage of the glass layer 310 is about 0.3 kgf or more than 0.3 kgf.

According to an embodiment, in view of the result of the third evaluation disclosed in FIG. 13, the glass layer 310 may be implemented such that the puncture resistance (e.g., breaking load or determination strength) is about 3 kgf, or greater than 3 kgf.

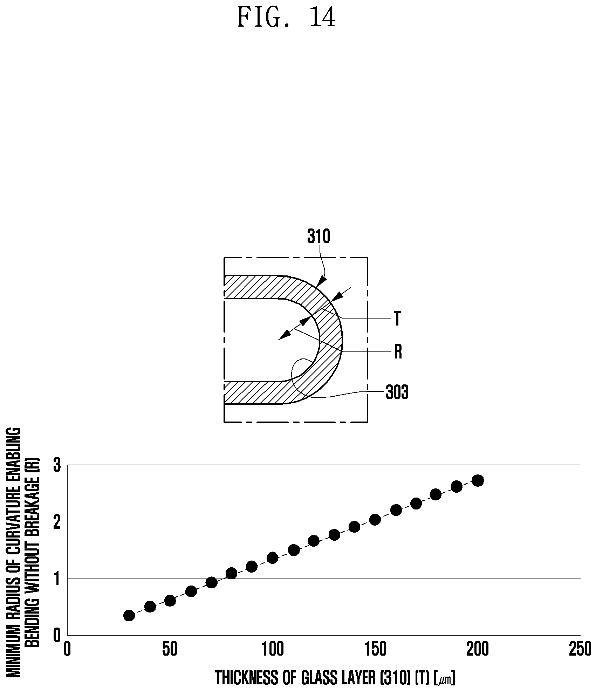

FIG. 14 is a cross-sectional view illustrating the glass layer 310 in the folded state of the electronic device 1 (see FIG. 1), and a graph showing the minimum radius of curvature R that allows the glass layer 310 to be bent without breaking depending on the thickness T of the glass layer 310, according to an embodiment.

Referring to FIG. 14, bending stress generated in a bending area of the glass layer 310 may result from the collision of an increasing force (e.g., tensile stress) on one surface of the bending area and a decreasing force (e.g., compressive stress) on the other surface of the bending area. The bending stress generated in the bending area of the glass layer 310 may be proportional to the thickness T of the glass layer 310 and inversely proportional to the radius of curvature R. The radius of curvature R may be substantially based on the inner surface 310a of the glass layer 310 when the glass layer 310 is bent. In an embodiment, the thickness T of the glass layer 310 may be provided such that the glass layer 310 has a minimum radius of curvature R of about 5 mm, or greater than 0 mm and less than 5 mm that enables the glass layer 310 to be bent without breaking.

An electronic device according to various embodiments of the disclosure is an electronic device including a flexible display panel 301, and may include a flexible window 302 disposed in a first direction, in which the flexible display panel 301 displays an image, to protect the flexible display panel 301, and configured to be bent and unbent, wherein the flexible window 302 may include a first part 304 located in a first area of the flexible window 302 including a first recess 311 formed on a first surface of the flexible window 302 and is bent and unbent about the bending axis and a second part 305 which is thicker than the first part 304 and is located in a second area of the flexible window 302, wherein the first part 304 may include a reinforcement part 313 formed on the surface of the first part 304 to be oriented in a direction vertical to the direction of the bending and unbending.

In various embodiment, the reinforcement part 313 may include a rib 313b protruding from the first part 304.

In various embodiment, the rib 313b may be located at a center of the first part 304 with respect to the bending axis.

In various embodiment, wherein the reinforcement part 313 may include a reinforcement groove 313a recessed from a surface of the first part 304.

In various embodiment, the reinforcement groove 313a may be located to be symmetrically spaced apart from the center of the first part 304 with respect to the bending axis.

In various embodiment, the electronic device may include a second recess 312 formed on a surface opposite to the first recess 311 with respect to a thickness direction of the flexible window 302.

In various embodiment, a boundary between the first part 304 and the second part 305 has a tapered shape in a thickness direction.

In various embodiment, the flexible window 302 may include a transparent polymer layer 320 located in the recessed area of the first part 304.

In various embodiment, a thickness of the second part 305 exceeds 30 micrometers.

In various embodiment, the flexible window 302 may be manufactured by a method comprising a reinforcement part 313 processing operation of processing and forming the reinforcement part 313 by recessing a surface of the glass layer, a masking operation of locating a mask formed to cover a surface of the second part 305 and expose an area corresponding to the first recess 311 with respect to a surface of the glass layer; and an etching operation of etching the first recess 311.

A flexible window 302 disposed on a flexible display panel 301 of an electronic device, and configured to be bent and unbent about a bending axis, may comprise:
a first part 304 located in a first area of the flexible window 302 may include a first recess 311 formed on a first surface of the flexible window 302, and is bent and unbent about the bending axis, and
a second part 305 which is thicker than the first part 304 and is located in a second area of the flexible window 302,
and wherein the first part 304 may include a reinforcement part 313 formed on the surface of the first part 304 to be oriented in a direction vertical to the direction of the bending and unbending.

In various embodiment, the reinforcement part 313 may include a rib 313b protruding from the first part 304.

In various embodiment, the rib 313b may be located at a center of the first part 304 with respect to the bending axis.

In various embodiment, wherein the reinforcement part 313 may include a reinforcement groove 313a recessed from a surface of the first part 304.

In various embodiment, the reinforcement groove 313a may be located to be symmetrically spaced apart from the center of the first part 304 with respect to the bending axis.

In various embodiment, the electronic device may include a second recess 312 formed on a surface opposite to the first recess 311 with respect to a thickness direction of the flexible window 302.

In various embodiment, a boundary between the first part 304 and the second part 305 has a tapered shape in a thickness direction.

In various embodiment, the flexible window 302 may include a transparent polymer layer 320 located in the recessed area of the first part 304.

In various embodiment, a thickness of the second part 305 exceeds 30 micrometers.

In various embodiment, the flexible window 302 may be manufactured by a method comprising a reinforcement part 313 processing operation of processing and forming the reinforcement part 313 by recessing a surface of the glass layer, a masking operation of locating a mask formed to cover a surface of the second part 305 and expose an area corresponding to the first recess 311 with respect to a surface of the glass layer; and an etching operation of etching the first recess 311.

In various embodiment, puncture resistance of the second part 305 and the first part 304 may be 3 kgf or more.

In various embodiment, the flexible window 302 may include a glass layer, and wherein in the first part 304, the glass layer may be configured not to be broken during a pen drop test from a height of at least 6 cm.

In various embodiment, in the first part 304, the glass layer may be configured not to be broken by a pen tip during a pen pressing test with a force of at least 0.3 kgf.

In various embodiment, in case that the flexible window 302 is bent, a radius of curvature of the first part 304 may be less than or equal to 0.5 mm.

In various embodiment, the flexible window 302 may include plurality of the second part 305 spaced apart by the first part 304.

In various embodiment, at least some of reinforcement part 313 is formed on a surface of the second recess 312.

In various embodiment, the reinforcement part 313 may have a rounded cross-sectional shape.

The embodiments disclosed herein, as disclosed in the specification and drawings, are merely provide particular examples in order to easily describe the technical matters according to the embodiments disclosed herein and help to understand the embodiments disclosed herein, and are not intended to limit the scope of the embodiments disclosed herein. Therefore, it should be construed that the scope of the various embodiments disclosed herein includes, in addition to the embodiments disclosed herein, all modifications or variations derived from the technical ideas of the various embodiments disclosed herein.

## Claims

1. An electronic device comprising a flexible display panel, the electronic device comprising:
a flexible window disposed in a first direction, in which the flexible display panel displays an image, to protect the flexible display panel, and configured to be bent and unbent,
wherein the flexible window comprises:
a first part located in a first area of the flexible window comprises a first recess formed on a first surface of the flexible window, and is bent and unbent about the bending axis; and
a second part which is thicker than the first part and is located in a second area of the flexible window, and
wherein the first part comprises a reinforcement part formed on the surface of the first part to be oriented in a direction vertical to the direction of the bending and unbending.

2. The electronic device of claim 1, wherein the reinforcement part comprises a rib located at a center of the first part with respect to the bending axis and protruding from the first part.

3. The electronic device of claim 1, wherein the reinforcement part comprises a reinforcement groove recessed from a surface of the first part and located to be symmetrically spaced apart from the center of the first part with respect to the bending axis.

4. The electronic device of claim 1, comprising a second recess formed on a surface opposite to the first recess with respect to a thickness direction of the flexible window.

5. The electronic device of claim 1, wherein a boundary between the first part and the second part has a tapered shape in a thickness direction, and
wherein the flexible window comprises a transparent polymer layer located in the recessed area of the first part.

6. The electronic device of claim 1, wherein a thickness of the second part exceeds 30 micrometers.

7. The electronic device of claim 1, wherein the flexible window is manufactured by a method comprising:
a reinforcement part processing operation of processing and forming the reinforcement part by recessing a surface of the glass layer;
a masking operation of locating a mask formed to cover a surface of the second part and expose an area corresponding to the first recess with respect to a surface of the glass layer; and
an etching operation of etching the first recess.

8. A flexible window disposed on a flexible display panel of an electronic device, and configured to be bent and unbent about a bending axis, comprising:
a first part located in a first area of the flexible window comprises a first recess formed on a first surface of the flexible window, and is bent and unbent about the bending axis; and
a second part which is thicker than the first part and is located in a second area of the flexible window, and
wherein the first part comprises a reinforcement part formed on the surface of the first part to be oriented in a direction vertical to the direction of the bending and unbending.

9. The flexible window of claim 8, wherein the reinforcement part comprises a rib located at a center of the first part with respect to the bending axis and protruding from the first part.

10. The flexible window of claim 8, wherein the reinforcement part comprises a reinforcement groove recessed from a surface of the first part and located to be symmetrically spaced apart from the center of the first part with respect to the bending axis.

11. The flexible window of claim 8, comprising a second recess formed on a surface opposite to the first recess with respect to a thickness direction of the flexible window,
wherein at least some of reinforcement part is formed on a surface of the second recess, and the reinforcement part has a rounded cross-sectional shape.

12. The flexible window of claim 8,
comprising a transparent polymer layer located in the recessed area of the first part, and
wherein a boundary between the first part and the second part has a tapered shape in a thickness direction.

13. The flexible window of claim 8, wherein a thickness of the second part exceeds 30 micrometers,
wherein puncture resistance of the second part and the first part is 3 kgf or more,
wherein in the first part, the glass layer is configured not to be broken during a pen drop test from a height of at least 6 cm, and
wherein in case that the flexible window is bent, a radius of curvature of the first part is less than or equal to 0.5 mm.

14. The flexible window of claim 8, wherein the flexible window is manufactured by a method comprising:
a reinforcement part processing operation of processing and forming the reinforcement part by recessing a surface of the glass layer;
a masking operation of locating a mask formed to cover a surface of the second part and expose an area corresponding to the first recess with respect to a surface of the glass layer; and
an etching operation of etching the first recess.

15. The flexible window of claim 11, comprising plurality of the second part spaced apart by the first part.
